# EUROPEAN PATENT APPLICATION

(11) **EP 2 166 362 A1**
(43) Date of publication of application: **24.03.2010**
(21) Application number: 09252201.0
(22) Date of filing: 16.09.2009
(51) Int. Cl.: G01R 1/067

(54) **Probe assembly**

(30) Priority: 23.09.2008 US 235913
(71) Applicant: TEKTRONIX, INC., Beaverton, OR 97077-0001 (US)
(72) Inventor: Ruppelt, Christian K., Portland, Oregon 97231 (US)
(74) Representative: Brinck, David John Borchardt

(57) **Abstract**

A probe assembly for acquiring signals from an electrical device with:
a probe body (10);
a signal conductor extending from the body for electrical connection to an instrument;an electrically conductive probe tip electrically connected to the signal conductor, extending from the body, and having a free end for contacting the device;
an attachment element (80,82) operably securable to the device;
the attachment element having a facility for mechanically supporting the probe body; and
the probe body having a plurality of attachment facilities (16), each adapted to connect to the attachment element, such that the probe body is attached in a different position with respect to the device depending on which of the attachment facilities is connected to the attachment element.

## Description

### Field of the Invention

The present invention relates to an adjustable probe head for use in connection with intercepting and transferring signals in an electronic device. The adjustable probe head has particular utility in connection with acquiring signals from an electrical device on a test board and transferring them to an oscilloscope for analysis.

### Background of the Invention

Probe heads are desirable for acquiring signals from an electrical device on a test board and transferring them to an oscilloscope for analysis. Analyzing signals acquired from an electrical device on a target printed circuit board to determine what the signals are doing at a logical level is an important part of validating or troubleshooting a circuit design. Signal analysis can also be useful in a service and repair environment to diagnose malfunctions. It is especially desirable to test electronic components when they are fully assembled into finished products to identify design problems, such as overheating, during the development phase. Such testing can also be useful during full-scale production to provide quality control for the manufacturing process.

Unfortunately, while it is desirable to test electronic components when they are fully assembled into finished products during both product development and full-scale production, the test environment poses numerous obstacles to probe placement. Because the electronic components are usually contained in a housing, there is limited space for positioning probes. Furthernore, boards may be a stacked in close proximity to one another and/or inserted into one another, which can create additional probe location constraints. Finally, it may be desirable to test a device using multiple probes simultaneously, which introduces additional probe placement restrictions.

Probe head location is critical because demand for higher data transfer rates has created a need for printed circuit boards to transmit signals at ever-increasing frequencies. At high frequencies, such as the microwave frequencies used in Double Data Rate (DDR) memory modules, existing probes create undesirable capacitive loading because of the length of their probe tips. Long probes slow down high-speed signals and/or cause signal reflections that disturb the signal being measured. Therefore, it is desirable to position probe heads as close as possible to the location being probed to maximize signal quality.

The use of clips that receive probes is known in the prior art. For example, clips have been used to secure probes to printed circuit boards undergoing tests. However, these clips only enable the probes to be positioned perpendicularly to the boards' surface. Furthermore, these probe heads are very expensive because the clips and a flex circuit are integrated with the probe. Flex circuits are created by mounting electronic devices on flexible high-performance substrates. Flex circuits are often used as connectors in various applications where flexibility, space savings, or production constraints limit the serviceability of rigid circuit boards or hand wiring. Because of the prior art probe heads' cost, additional effort must be taken to unsolder them from the device being tested once a test is completed so they can be reused.

Therefore, a need exists for a new and improved adjustable probe head that can be used for acquiring signals from an electrical device on a test board and transferring them to an oscilloscope for analysis. In this regard, the various embodiments of the present invention substantially fulfill at least some of these needs. In this respect, the adjustable probe head according to the present invention substantially departs from the conventional concepts and designs of the prior art, and in doing so provides an apparatus primarily developed for the purpose of acquiring signals from an electrical device on a test board and transferring them to an oscilloscope for analysis.

### Summary of the Invention

The present invention provides an improved adjustable probe head, and overcomes the above-mentioned disadvantages and drawbacks of the prior art. As such, the general purpose of the present invention, which will be described subsequently in greater detail, is to provide an improved adjustable probe head that has all the advantages of the prior art mentioned above.

To attain this, the preferred embodiment of the present invention essentially comprises a probe head enclosing a plurality of test paths with a header that is attached to one of its opposing sides and electrically connected to the test paths. The header may be removably attached to the probe head. The probe head may enclose a board with an attached integrated circuit unit, and there may be a power cable and a signal cable connected to the board. There may be a clip that removably retains the probe head by releasably engaging with at least one of a plurality of slots on the sides of the probe head. The invention also includes a method of acquiring signals from an electrical device mounted on a test board. The electrical device may be a double data rate memory module. There are, of course, additional features of the invention that will be described hereinafter and which will form the subject matter of the claims attached.

There has thus been outlined, rather broadly, the more important features of the invention in order that the detailed description thereof that follows may be better understood and in order that the present contribution to the art may be better appreciated.

### Brief Description of the Drawings

FIGURE 1 is a side view of the current embodiment of a plurality of adjustable probe heads constructed in accordance with the principles of the present invention depicting the adjustable probe heads connected to an oscilloscope.

FIGURE 2 is an exploded view of the current embodiment of the adjustable probe head constructed in accordance with the principles of the present invention.

FIGURE 3 is a top side view of the current embodiment of the header constructed in accordance with the principles of the present invention.

FIGURE 4a-4c are a top side view, side view, and bottom side view, respectively of the current embodiment of the flex circuit header constructed in accordance with the principles of the present invention.

FIGURE 5 is a top perspective view of the current embodiment of the wide-body header constructed in accordance with the principles of the present invention.

FIGURE 6 is a top perspective view of a plurality of adjustable probe heads of the present invention connected by headers of the present invention to a test board.

FIGURE 7 is a top perspective view of a plurality of adjustable probe heads of the present invention connected by a header and a wide-body header of the present invention to a test board.

FIGURE 8 is a top perspective exploded of an adjustable probe head of the present invention connected by a header of the present invention to a test board.

FIGURE 9 is a top perspective exploded view of a plurality of adjustable probe heads of the present invention connected by a header and a flex circuit header to a test board.

FIGURE 10 is a top perspective view of a plurality of adjustable probe heads of the present invention connected by a header and a flex circuit header to a test board.

FIGURE 11 is a flowchart view of the method of acquiring signals from an electrical device mounted on a test board of the present invention.

The same reference numerals refer to the same parts throughout the various figures.

### Description Of The Current Embodiment

A preferred embodiment of the apparatus for a test and measurement instrument of the present invention is shown and generally designated by the reference numeral 10.

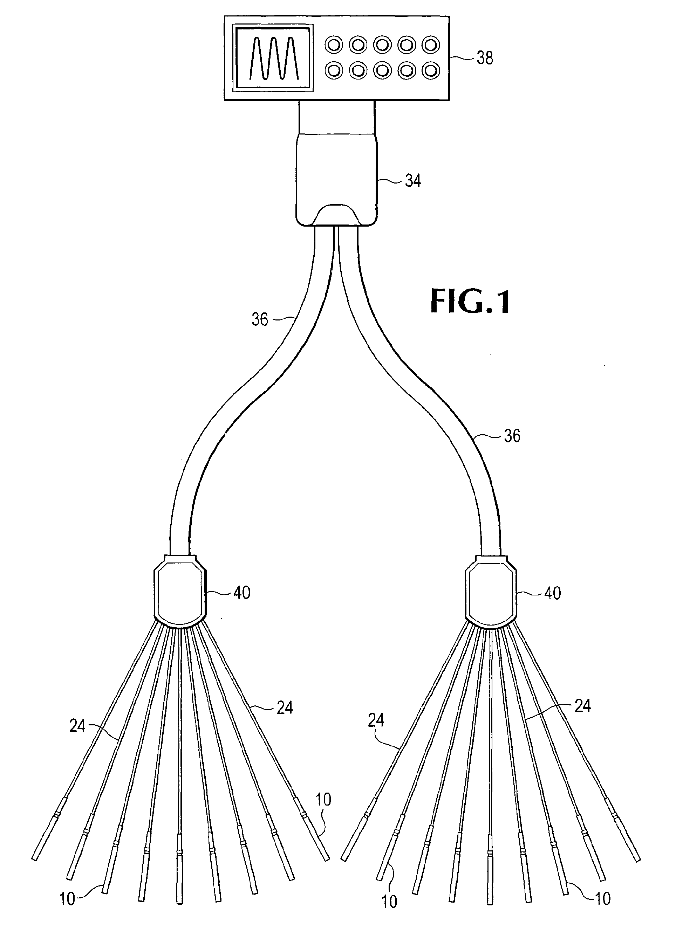

FIGURE 1 illustrates improved adjustable probe head 10 of the present invention. More particularly, seventeen adjustable probe heads 10 are depicted connected to an oscilloscope 38. Two coaxial ribbon cables 36 have one end connected by a probe paddle 34 to the oscilloscope 38. The coaxial ribbon cables 36 each pass through a cable splitter 40 that separates the coaxial ribbon cables 36 into seventeen sets of paired cables 24. Each of the paired cables 24 is attached to one end of one of the adjustable probe heads 10. A user can use as few as one of the adjustable probe heads 10 or as many as all seventeen probe heads simultaneously to obtain signals from a device under test. Each adjustable probe head 10 can function independently as a digital or analog probe.

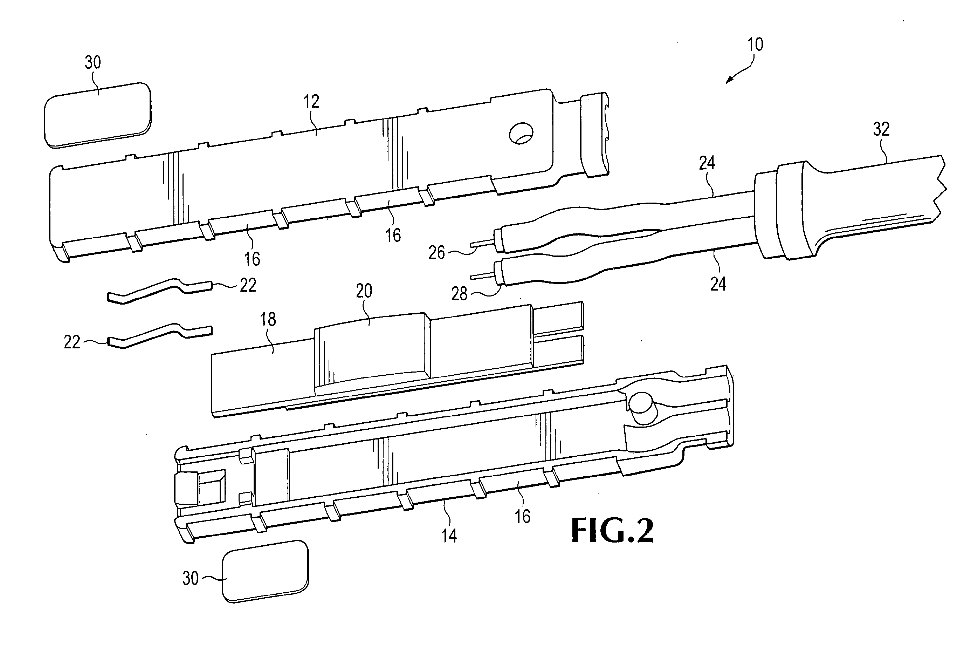

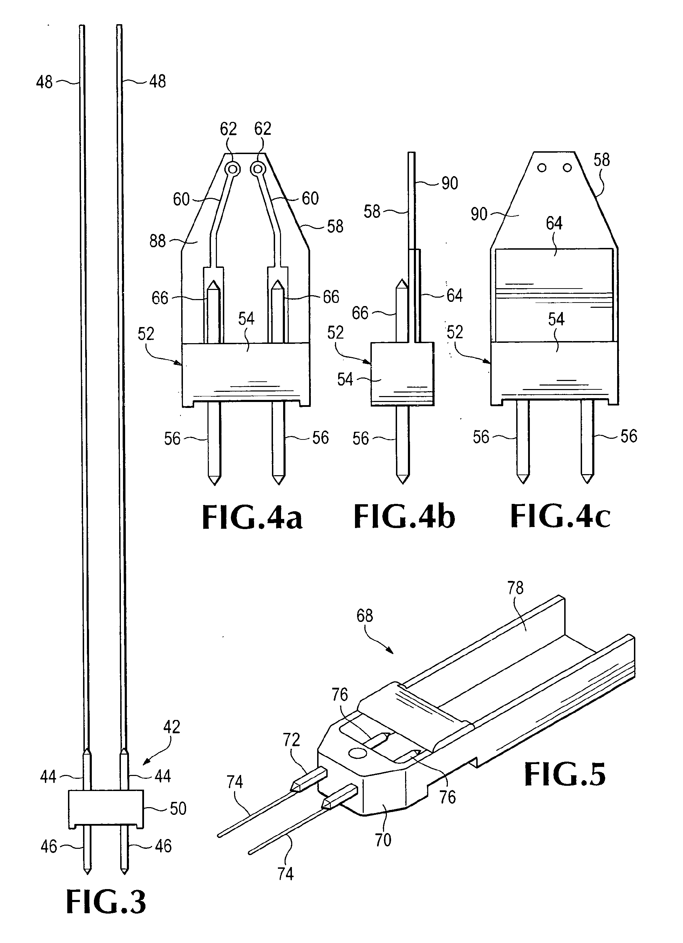

FIGURE 2 illustrates an exploded view of the adjustable probe head 10. The centers 26 and shields 28 of paired cables 24 are soldered to one end of a probe head circuit board 18. One end of a pair of electrical contact spring clips 22 is soldered to the opposing end of the probe head circuit board 18. The spring clips 22 are single-sided contacts that releasably secure and electrically connect to a header 42 (illustrated in Figure 3), flex circuit header 52 (illustrated in Figures 4a-4c), or a wide-body header 68 (illustrated in Figure 5) to the adjustable probe head 10. The probe head circuit board 18 has an attached integrated circuit unit 20.

The probe head circuit board 18 and integrated circuit unit 20 make the adjustable probe head 10 a fully active probe head, meaning that it pre-processes acquired signals before sending them to the oscilloscope 38 over one of the paired cables 24. This enables the adjustable probe head 10 to process up to 8 GHz signals. However, the adjustable probe head 10 could also be a passive probe head that lacked a probe head circuit board 18 and an integrated circuit unit 20, although this would limit its ability to process signals exceeding 500 MHz using current technologies.

The other paired cable 24 supplies power to the integrated circuit unit 20. In the current embodiment, power is supplied through the center of one of the paired cables 24 at +3 V and through the shield 28 of that paired cable 24 at -3 V. When assembled, heat shrink tubing 32 passes over paired cables 24 and one end of the upper cover 12 and the lower cover 14 to secure the upper cover 12 and lower cover 14 to the paired cables 24 and to provide flex and bend strain relief. Labels 30 are attached to the upper cover 12 and lower cover 14 to uniquely identify the adjustable probe head 10.

FIGURE 3 illustrates a header 42 that can be releasably secured to an adjustable probe head 10. Two round pins 46 protrude from one side of a body 50, and two square pins 44 protrude from the opposing side of the body 50. The square pins 44 and round pins 46 are in electrical contact with one another. One end of a stiff probe wire 48 is welded onto each of the square pins 44. Two wires 48 are used because a single wire 48 would result in very poor signal quality and extremely low performance. Two wires 48 enable one wire 48 to be used for the signal and one for ground. Alternatively, the wires 48 can be used as a differential pair. Differential pairs are used to carry differential or semi-differential signals such as high-speed digital serial interfaces and high-quality and/or high frequency analog signals. Differential pairs minimize crosstalk and electromagnetic interference and achieve constant impedance, which is important in high-speed signal transmission. When the header 42 is releasably secured to an adjustable probe head 10, the spring clips 22 engage with the round pins 46. In the current embodiment, the round pins 46 have 0.100 inches center-to-center spacing, the round pins 46 are 0.120 inches in length, and the combined length of the square pins 44, the body 50, and the round pins 46 is 0.320 inches. The wires 48 are 2 inches long and 0.008 inches wide in the current embodiment.

FIGURES 4a-4c illustrate a flex circuit header 52 that can be releasably secured to an adjustable probe head 10 and is especially suitable for probing vias. Two round pins 56 protrude from one side of a body 54, and two square pins 66 protrude from the opposing side of the body 54. The square pins 66 and round pins 56 are in electrical contact with one another. When the flex circuit header 52 is releasably secured to an adjustable probe head 10, the spring clips 22 engage with the round pins 46. One end of a flexible substrate 58 is attached by its top surface 88 to the side of body 54 below the square pins 66. Transmission lines 60 are present on the top surface 88 of the flexible substrate 58. Each transmission line 60 has one end electrically connected to one of the square pins 66, and its other end terminates in a pad 62. Two transmission lines 60 are used so that one transmission line 60 can be used for the signal and one for ground. Alternatively, the transmission lines 60 can be used as a differential pair.

The bottom surface 90 of the flexible substrate 58 has a stiffener 64 attached to it. The stiffener 64 covers approximately one-half of the flexible substrate 58, beginning with the flexible substrate's 58 attachment point to the body 54, and prevents that portion of the flexible substrate 58 from flexing. The stiffener 64 ensures the electrical connection between the square pins 66 and the transmission lines 60 is not disrupted. In the current embodiment, the round pins 56 have 0.100 inches center-to-center spacing, the round pins 56 are 0.120 inches in length, and the combined length of the square pins 44, the body 50, and the round pins 46 is 0.320 inches. The body 54 has a width of 0.100 inches, the flexible substrate 58 has a total length of 0.300 inches and a flexible length of 0.150 inches, and the flexible length 92 of the flexible substrate 58 tapers to a width of 0.065 inches in the current embodiment.

FIGURE 5 illustrates a wide-body header 68 that can be releasably secured to an adjustable probe head 10. Two round pins 76 protrude from one side of a body 70, and two square pins 72 protrude from the opposing side of the body 70. The square pins 72 and round pins 76 are in electrical contact with one another. One end of a wire 74 is welded onto each of the square pins 72. Two wires 74 are used so that one wire 74 can be used for the signal and one for ground. Alternatively, the wires 74 can be used as a differential pair. When the wide-body header 68 is releasably secured to an adjustable probe head 10, the spring clips 22 engage with the round pins 76. Clip 78, which extends from body 70 adjacent to round pins 76, further attaches wide-body header 68 to an adjustable probe head 10 by releasably engaging with at least one of the slots 16 on the upper cover 12 and lower cover 14. The wide-body header 68 is used when an adjustable probe head 10 is to be positioned parallel to the surface of a device to be tested and is sufficient to removably secure the adjustable probe head 10 to the surface of a device to be tested. In the current embodiment, the square pins 72 are 0.100 inches in length, the wires 74 are 2.0 inches in length, and the combined clip 78 and body 68 are 0.877 inches in length.

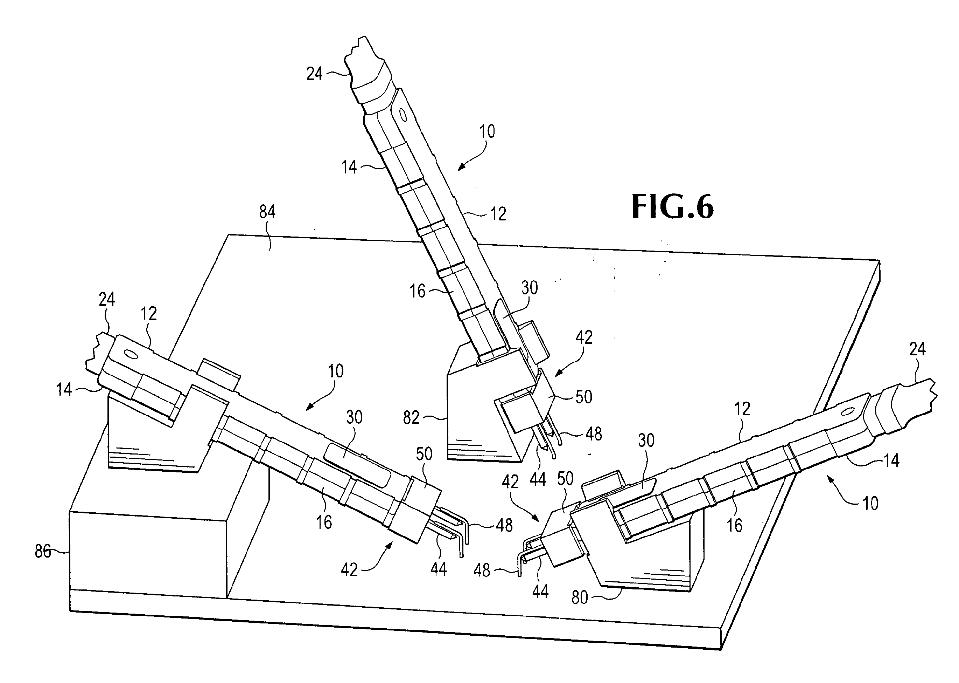

FIGURE 6 illustrates headers 42, a first clip 80, and a second clip 82 being used to releasably secure adjustable probe heads 10 to a test board 84. In this example, signals are being collected from a DDR memory module 86 attached to the test board 84. However, the DDR memory module 86 can also be any integrated circuit, power regulator, or even a mezzanine board. The free end of each wire 48 is soldered to desired features on the test board 84 relating to the DDR memory module 86, such as leads, transmission lines, or vias, and the first clip 80 and second clip 82 are glued or taped or otherwise attached to the test board 84 or the DDR memory module 86 itself. First clip 80 and second clip 82 are used when it is desirable to attach an adjustable probe head 10 to a test board 84 at an angle. The first clip 80 and second clip 82 releasably engage with the slots 16 on the upper cover 12 and lower cover 14. The first clip 80 and second clip 82 can be placed on the test board 84 when it is assembled and can be left in place after a test since they are very inexpensive compared to the adjustable probe heads 10. The adjustable probe heads 10 are releasably secured to the test board 84 by the first clip 80, second clip 82, and header 42 and are easily removed after the test. In the current embodiment, first clip 80 releasably secures an adjustable probe head 10 to a test board 84 at a 25° angle, and second clip 82 releasably secures an adjustable probe head 10 to a test board 84 at a 55° angle.

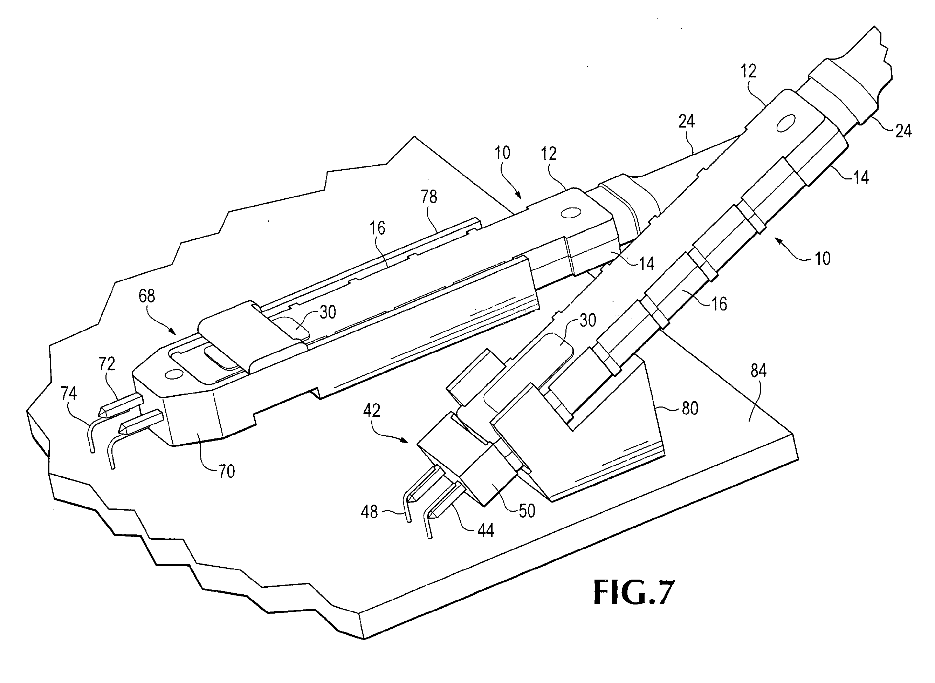

FIGURE 7 illustrates a wide-body header 68 and a header 42 and first clip 80 being used to releasably secure adjustable probe heads 10 to a test board 84. The free end of the wires 48 and 74 is soldered to desired features on the test board 84. The clip 78 and first clip 80 are glued or taped to the test board 84 and releasably engage with the slots 16 on the upper cover 12 and lower cover 14. They can be placed on the test board 84 when the test board 84 is assembled and can be left in place after a test since they are very inexpensive compared to the adjustable probe heads 10.

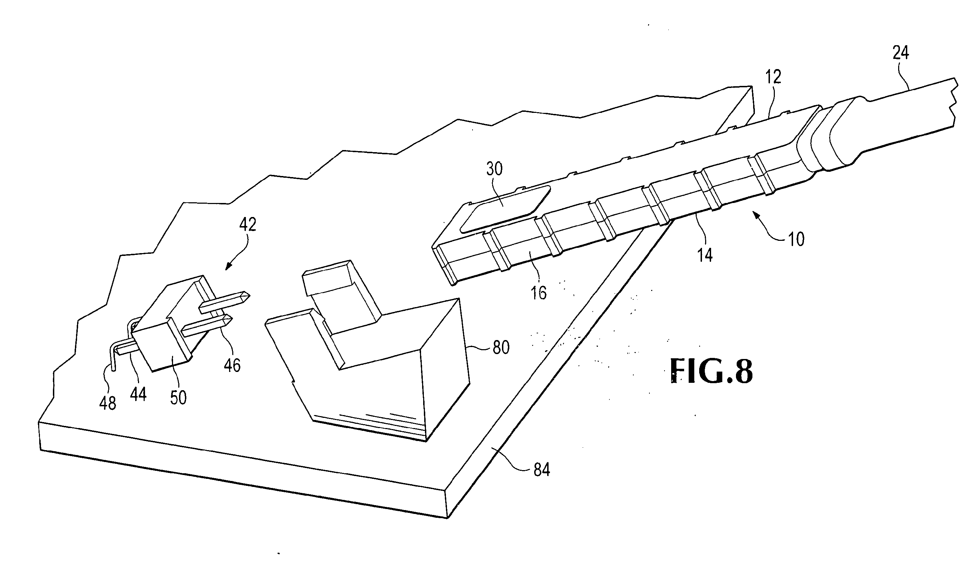

FIGURE 8 illustrates an exploded view of a header 42 and first clip 80 being used to releasably secure an adjustable probe head 10 to a test board 84. The header 42 and first clip 80 are placed on the test board 84 when it is assembled. Prior to conducting a test, the probe head 10 is removably connected to the header 42 by releasably engaging the spring clips 22 in the probe head 10 with the header's 42 round pins 46. The probe head 10 is simultaneously removably connected to the first clip 80 by engaging the first clip 80 with at least one of the probe head's 10 slots 16.

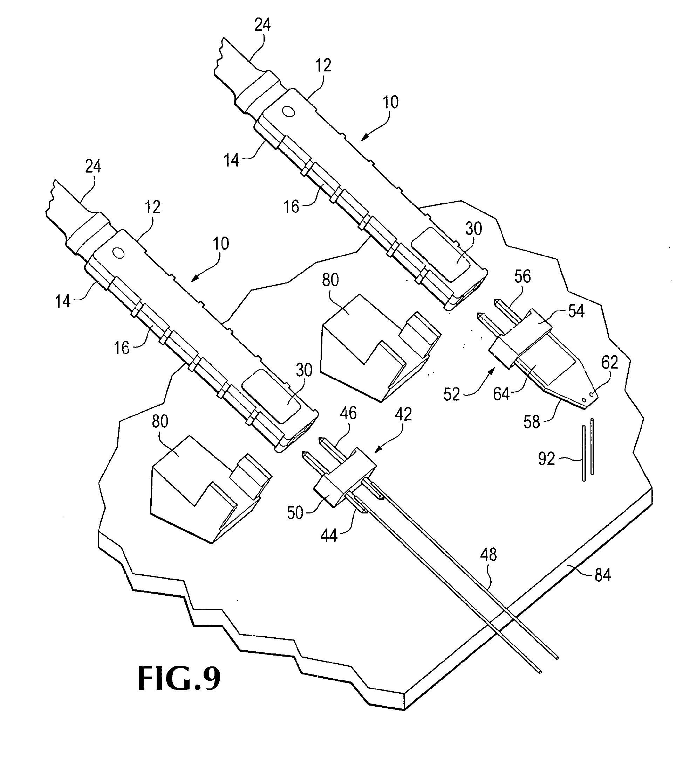

FIGURE 9 illustrates an exploded view of a header 42, first clip 80, and a flex circuit header 52 being used to releasably secure a plurality of adjustable probe heads 10 to a test board 84. When an adjustable probe head 10 is to be attached to a test board 84 at an angle, either the flex circuit header 52 or the header 42 is used to connect the adjustable probe head 10 to the desired features on the test board 84. This is accomplished by soldering the pads 62 on the flex circuit header 52 to wires 92, which are in turn soldered to those features, or by soldering the free end of the wires 48 on the header 42 to those features.

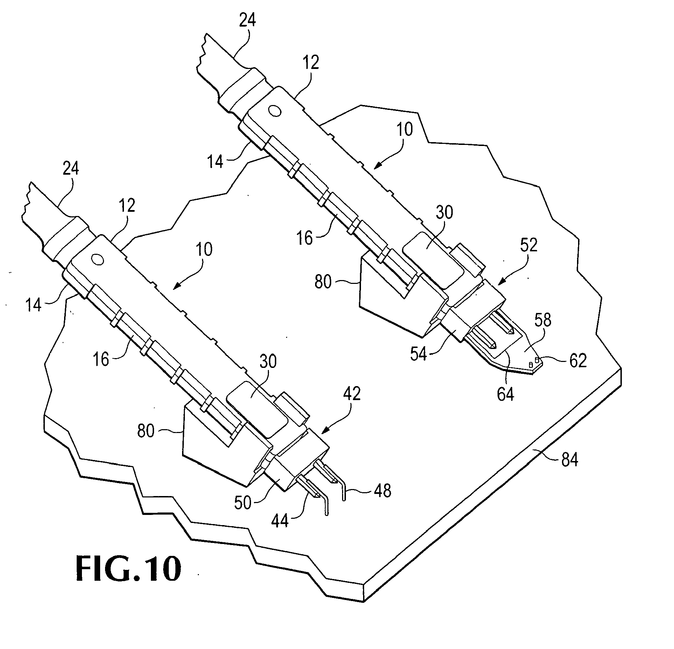

FIGURE 10 illustrates a header 42, first clip 80, and a flex circuit header 52 being used to releasably secure a plurality of adjustable probe heads 10 to a test board 84. Prior to conducting a test, the probe head 10 removably connected to the header 42 by releasably engaging the spring clips 22 in the probe head 10 with the header's 42 round pins 46, or the probe head 10 is removably connected to the flex circuit header 52 by releasably engaging the spring clips 22 in the probe head 10 with the flex circuit header's 52 round pins 56. The probe head 10 is simultaneously removably connected to a first clip 80 by engaging the first clip 80 with at least one of the probe head's 10 slots 16.

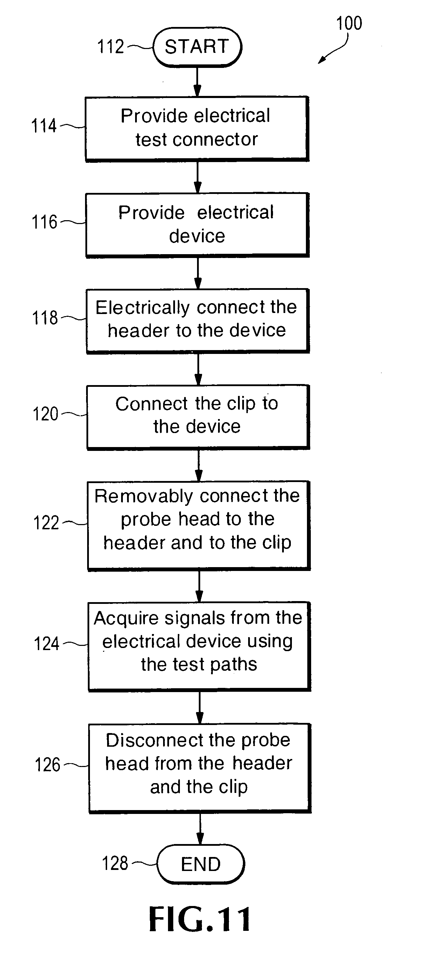

FIGURE 11 illustrates a method of acquiring signals from an electrical device mounted on a test board (100). The method begins (112) by providing an electrical test connector of the current invention (114) and an electrical device (116). The desired header is subsequently electrically connected to the device by soldering its wires or pads to a feature on the device (118). The clip is also connected to the device, typically using glue or tape (120). The probe head is then removably connected to the header by releasably engaging the spring clips in the probe head with the header's round pins (122). The probe head is removably connected to the clip by engaging the clip with at least one of the probe head's slots (122). After signals are acquired from the electrical device using the test paths in the probe head (124), the probe head is disconnected from the header and the clip (126), both of which remain on the board, and then the method terminates (128).

While current embodiments of the adjustable probe head have been described in detail, it should be apparent that modifications and variations thereto are possible, all of which fall within the true spirit and scope of the invention. With respect to the above description then, it is to be realized that the optimum dimensional relationships for the parts of the invention, to include variations in size, materials, shape, form, function and manner of operation, assembly and use, are deemed readily apparent and obvious to one skilled in the art, and all equivalent relationships to those illustrated in the drawings and described in the specification are intended to be encompassed by the present invention. For example, any suitable electronic device can be probed instead of the DDR memory module described. Furthermore, any quantity of adjustable probe heads may be used instead of the 1 to 17 described.

Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.
The description also includes the following numbered clauses, corresponding to alternative aspects of the invention.
1. An electrical test connector comprising:
   a probe head heaving opposing sides and opposing ends;
   a header attached to one of the probe head's opposing sides; and
   a plurality of test paths enclosed by the probe head, each electrically connected to the header.
2. The electrical test connector as defined in clause 1, further comprising a plurality of slots, wherein the opposing sides of the probe head define a plurality of slots therein to comprise the slots.
3. The electrical test connector as defined in clause 1, wherein the header comprises:
   a body having opposing ends;
   a plurality of round pins having a center protruding from one of the opposing ends of the body;
   a plurality of square pins having a center protruding from one of the opposing ends of the body opposite the round pins; and
   a plurality of wires having opposing ends and a center, wherein each of the square pins has one end of one of the wires attached thereto.
4. The electrical test connector as defined in clause 3, wherein the wires are welded to the square pins.
5. The electrical test connector as defined in clause 3, wherein the center-to-center spacing of the square pins, the wires, and the round pins is substantially equal to 0.100 inches.
6. The electrical test connector as defined in clause 1, wherein the header is removably attached to the probe head.
7. The electrical test connector as defined in clause 1, further comprising:
   a board having circuitry enclosed by the probe head and electrically connected to the header, wherein the circuitry comprises the plurality of test paths;
   an integrated circuit unit attached to the board;
   a power cable connected to the board; and
   a signal cable connected to the board.
8. The electrical test connector as defined in clause 1, wherein the header comprises:
   a body having opposing ends;
   a plurality of round pins having a center protruding from one of the opposing ends of the body;
   a plurality of square pins having a center protruding from one of the opposing ends of the body opposite the round pins;
   a flexible substrate having opposing ends, a top surface, and a bottom surface with one end attached to one of the opposing ends of the body beneath the square pins;
   a plurality of transmission lines having opposing ends attached to the top surface of the flexible substrate, wherein each of the square pins is electrically connected to one end of one of the transmission lines; and
   a plurality of pads, wherein each of the transmission lines has a pad connected to one of its opposing ends opposite the square pins.
9. The electrical test connector as defined in clause 8, further comprising a stiffener attached to the bottom surface of the flexible substrate.
10. The electrical test connector as defined in clause 1, wherein the header comprises:
   a body having opposing ends;
   a plurality of round pins protruding from one of the opposing ends of the body;
   a plurality of square pins protruding from one of the opposing ends of the body opposite the round pins;
   a plurality of wires having opposing ends, wherein each of the square pins has one end of one of the wires attached thereto; and
   a clip extending longitudinally from the body adjacent to the round pins, wherein the clip removably retains the probe head by releasably interfacing with at least one of the slots.
11. The electrical test connector as defined in clause 2, further comprising a clip, wherein the clip removably retains the probe head by releasably engaging with at least one of the slots.
12. A method of acquiring signals from an electrical device mounted on a test board comprising the steps of:
   providing the test connector of clause 1;
   providing the electrical device;
   electrically connecting the free end of the probe tip to the device;
   connecting the attachment element to the device;
   removably connecting the signal conductor to the probe tip and the attachment element;
   acquiring signals from the electrical device using the signal conductor; and disconnecting the signal conductor from the probe tip and the attachment element;
      wherein the probe is removably connected to the signal conductor by a plurality of spring clips having opposing ends with one end attached to the probe head.

## Claims

1. A probe assembly for acquiring signals from an electrical device, the comprising:
a probe body;
a signal conductor extending from the body for electrical connection to an instrument;
an electrically conductive probe tip electrically connected to the signal conductor, extending from the body, and having a free end for contacting the device;
an attachment element operably securable to the device;
the attachment element having a facility for mechanically supporting the probe body; and
the probe body having a plurality of attachment facilities, each adapted to connect to the attachment element, such that the probe body is attached in a different position with respect to the device depending on which of the attachment facilities is connected to the attachment element.

2. The probe assembly as defined in claim 1, wherein the attachment facilities comprise a plurality of slots.

3. The probe assembly as defined in claim 1, wherein the attachment element comprises a clip.

4. The electrical test connector as defined in claim 3, wherein the clip removably retains the probe body at an angle between 0° and 90° with respect to the device.

5. The electrical test connector as defined in claim 4, wherein the clip removably retains the probe body at an angle in the range of 25° to 55° with respect to the device.

6. The electrical test connector as defined in claim 1, wherein the device is a double data rate memory module.

7. The electrical test connector as defined in claim 1, wherein the free end of the probe tip is soldered to the device.

8. The electrical test connector as defined in claim 1, wherein the probe tip is removably connected to the signal conductor.
